# EUROPEAN PATENT APPLICATION

(11) **EP 4 749 930 A1**
(43) Date of publication of application: **27.05.2026**
(21) Application number: 24214577.9
(22) Date of filing: 21.11.2024
(51) Int. Cl.: H03M 1/48

(54) **ANALOG-TO-DIGITAL CONVERTER FOR CONVERTING AN ANALOG INPUT SIGNAL INTO A DIGITAL REPRESENTATION AND METHOD OF OPERATING AN ANALOG-TO-DIGITAL CONVERTER**

(71) Applicant: Silicon Austria Labs GmbH, 8010 Graz (AT)
(72) Inventor: Moser, Bernhard A., 8010 Graz (AT); Lunglmayr, Michael, 8010 Graz (AT)
(74) Representative: Wirnsberger & Lerchbaum Patentanwälte OG

(57) **Abstract**

The invention concerns an analog-to-digital converter (1) for converting an analog input signal (Vᵢ) into a digital representation, the analog-to-digital converter (1) comprising comparison means for comparing an upper comparison value and a lower comparison value with the input signal (Vᵢ) and for outputting an indication signal indicating a crossing of the input signal (Vᵢ) with one of the comparison values, and comparison value generating means for generating the upper and lower comparison value depending on adjustment signals (Aᵤ, Aₗ) of a control logic (2). The comparison value generating means comprise an upper capacitor (Cᵤ) and a lower capacitor (Cₗ), wherein the upper comparison value depends on a charging state of the upper capacitor (Cᵤ) and the lower comparison value depends on a charging state of the lower capacitor (Cₗ), wherein in response to the crossing of the input signal (Vᵢ) with one of the comparison values for adjusting the comparison values, the charging states of the capacitors (Cᵤ, Cₗ) are changeable depending on the adjustment signals (Aᵤ, Aₗ).

## Description

The invention concerns an analog-to-digital converter for converting an analog input signal into a digital representation, the analog-to-digital converter comprising comparison means for comparing an upper comparison value and a lower comparison value with the input signal and for outputting an indication signal indicating a crossing of the input signal with one of the comparison values, and comparison value generating means for generating the upper comparison value and the lower comparison value depending on adjustment signals of a control logic of the analog-to-digital converter.

Further, the invention concerns a method of operating an analog-to-digital converter for converting an analog input signal into a digital representation, wherein with comparison means an upper comparison value and a lower comparison value are compared with the input signal and if the input signal crosses one of the comparison values, an indication signal is output to indicate the crossing of the input signal with the one of the comparison values, wherein with comparison value generating means the upper comparison value and the lower comparison value are generated depending on adjustment signals of a control logic.

Furthermore, the invention concerns a method for calibrating an analog-to-digital converter.

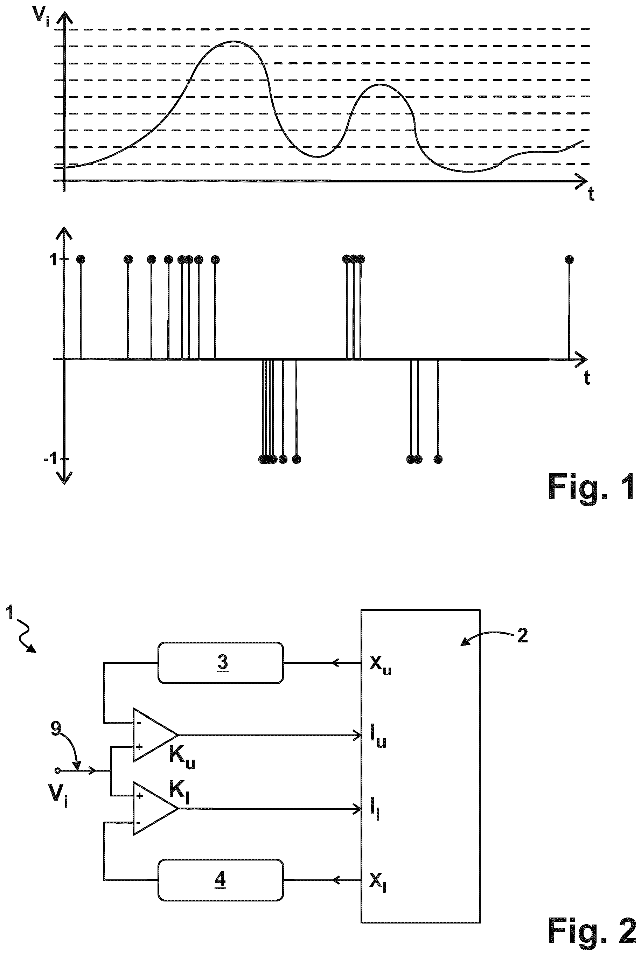

Analog-to-digital converters for converting an analog input signal into a digital representation based on level crossing sampling are known from the state of the art. In contrast to Shannon-based sampling, in which an analog input signal is sampled at regular time intervals, level crossing sampling acquires data when the input signal crosses certain predefined values, referred to as comparison values. For example, comparison values spaced at equal intervals can be provided for this purpose, whereby a +1 spike is generated when the input signal crosses one of the threshold values upwards and a -1 spike is generated when the input signal crosses one of the threshold values downwards. In this way, the input signal can be transferred from a signal space, represented by an amplitude of the input signal over time, into an event space, represented by occurring spikes overtime, shown in Fig.1. A time-dependent representation of the spikes enables reconstruction of the analog input signal.

Practicable sampling can be implemented by comparing the input signal at a particular time with an upper comparison value and a lower comparison value as threshold values, whereby a crossing of one of the comparison values by the input signal is detected and the comparison values are redefined after the crossing has occurred. This can be implemented practicably by feeding the input signal to two comparators, whereby one of the comparators compares the input signal with the upper comparison value and the other comparator compares the input signal with the lower comparison value, shown in Fig. 2. The outputs of the comparators can be connected to a control logic so that a crossing of the input signal with one of the comparison values determined by the comparators is detected by the control logic. The respective comparison value can, for example, be formed with a digital-to-analog unit, which converts a digital control signal from the control logic into the respective comparison value. Such a conversion is typically associated with a high energy requirement and/or low conversion accuracy of the analog-to-digital converter and often requires a complex electronic structure. Therefore, such an implementation is usually not beneficial for energy-efficient applications.

It is an object of the invention to provide an analog-to-digital converter for converting an analog input signal into a digital representation, which has a high operational efficiency, preferably with a small energy footprint while maintaining high accuracy.

A further object of the invention is to provide a method of operating an analog-to-digital converter for converting an analog input signal into a digital representation, which has a high operational efficiency, preferably with a small energy footprint while maintaining high accuracy.

Furthermore, it is an object of the invention to provide a method of calibrating an analog-to-digital converter which enables an analog-to-digital converter to be operated with high operational efficiency, preferably with a small energy footprint while maintaining high accuracy.

To achieve the foregoing object, the invention provides an analog-to-digital converter for converting an analog input signal into a digital representation, the analog-to-digital converter comprising comparison means for comparing an upper comparison value and a lower comparison value with the input signal and for outputting a, usually digital, indication signal indicating a crossing of the input signal with one of the comparison values, and comparison value generating means for generating the upper comparison value and the lower comparison value depending on adjustment signals of a control logic of the analog-to-digital converter, wherein the comparison value generating means comprise an upper capacitor and a lower capacitor, wherein the upper comparison value depends on a charging state of the upper capacitor and the lower comparison value depends on a charging state of the lower capacitor, wherein in response to the crossing of the input signal with one of the comparison values for adjusting the comparison values, the charging states of the capacitors are changeable depending on the adjustment signals of the control logic.

This invention is based on the idea of designing an analog-to-digital converter with an analog-to-digital architecture such that the converting accuracy is determined to a large extent by temporal measurements. In this way, it can be achieved that an uncertainty of the comparison values depends to a large extent on an uncertainty of the temporal measurement. Uncertainties of temporal measurements can usually be easily controlled and measured with high accuracy using digital hardware, for example. In that the comparison value generating means comprise the upper capacitor and the lower capacitor, components that can be practicably controlled are used to set the comparison values, wherein a charging state of the respective capacitor can be set, usually depending on a time constant that can be assigned to the respective capacitor, in particular a charging time of the respective capacitor. Usually, the upper comparison value can be set by setting a charging state of the upper capacitor. Usually, the lower comparison value can be set by setting the charging state of the lower capacitor. The control logic can be designed to output adjustment signals to the comparison value generating means, in particular depending on a time constant of the respective capacitor and/or on a respective comparison value to be set, in order to change with the comparison value generating means a charging state of the respective capacitor corresponding to a respective comparison value to be set. The charging state of the respective capacitor is usually changed, particularly with the comparison value generating means, depending on the adjustment signals. The comparison value generating means can be designed, usually separately from each other, to set the respective upper comparison value by adjusting the respective charging state of the upper capacitor and to set the respective lower comparison value by adjusting the respective charging state of the lower capacitor. The control logic can be designed to output upper adjustment signals and lower adjustment signals, in particular separately from one another, to the comparison value generation means in order to adjust the charging state of the upper capacitor depending on the upper adjustment signals and to adjust the charging state of the lower capacitor depending on the lower adjustment signals with the comparison value generation means. The comparison means can be designed, to compare the input signal with the upper comparison value and to compare the input signal with the lower comparison value, usually separately from each other. The comparison means are usually connected to the control logic in order to transmit the indicator signal to the control logic. In this way, the analog input signal can be efficiently converted with the analog-to-digital converter into a digital representation of the input signal. In an analogous manner, several upper comparison values and/or several lower comparison values can be provided, in particular generated and compared with the input signal. Especially, the comparison means can be designed to compare several upper comparison values and/or several lower comparison values with the input signal. Especially, the comparison value generating means may comprise several upper capacitors and/or several lower capacitors, wherein the respective upper comparison value depends on a charge state of a different one of the upper capacitors and/or the respective lower comparison value depends on a charge state of a different one of the lower capacitors.

The upper comparison value and the lower comparison value can be set such that the respective upper comparison value and the respective lower comparison value form a range window in which an actual value of the input signal is located. The upper comparison value is usually greater than the actual value of the input signal. The lower comparison value is usually smaller than the actual value of the input signal. Usually, if the input signal, in particular its actual value, crosses the upper comparison value or the lower comparison value, the respective comparison value crossed by the input signal or both comparison values, in particular the range window, is readjusted. This is usually done such that the input signal, in particular its actual value, is located in the readjusted range window, usually at a distance from the upper comparison value and the lower comparison value. The range windows can have the same size or different sizes. This can be carried out with the signal logic. The comparison means can be connected to the control logic, usually via an indication signal line of the analog-to-digital converter, in order to transmit the indication signal to the control logic. The comparison means can be designed to output an upper indication signal when the input signal crosses the upper comparison value and a lower indication signal when the input signal crosses the lower comparison value and preferably transmit it to the control logic via separate indication signal lines of the analog-to-digital converter. The indication signal can be implemented by the upper indication signal and lower indication signal. In particular, the comparison means can be connected to the control logic via an upper indication signal line for transmitting the upper indication signal and via a lower indication signal line for transmitting the lower indication signal. The upper indication signal line and lower indication signal line can form the separate indication signal lines. Usually, the upper comparison value and the lower comparison value are analog signals. The indication signal, in particular the upper indication signal and the lower indication signal, are usually digital signals. The control logic is usually designed to output the adjustment signals depending on the indicator signal, in particular the upper indicator signal and/or the lower indicator signal, in order to adjust the upper comparison value and/or lower comparison value in response to the crossing of the input signal with one of the comparison values. The respective crossing of the input signal with the upper comparison value is usually an exceeding of the upper comparison value by the input signal. The respective crossing of the input signal with the lower comparison value is usually a falling below of the upper comparison value by the input signal. The crossing usually refers to a, typically time-dependent, signal level of the input signal. The input signal can be represented as the signal level of the input signal over time. The input signal can be input to the analog-to-digital converter via an input line of the analog-to-digital converter. The digital representation can be output by the analog-to-digital converter in the form of a digital output signal.

The comparison means can comprise an upper comparator and a lower comparator to compare with the upper comparator the input signal with the upper comparison value and to compare with the lower comparator the input signal with the lower comparison value, wherein the respective comparator transmits a corresponding, usually digital, indication signal to the control logic if the respective comparison value is crossed by the input signal to indicate the crossing of the input signal with the respective comparison value. The upper comparator can be designed to receive the input signal and the upper comparison value via inputs of the upper comparator in order to compare with the upper comparator the input signal with the upper comparison value. A first input of the upper comparator can be connected to the upper capacitor in order to apply the upper comparison value to the first input. A second input of the upper comparator can be connected to the input line of the analog-to-digital converter in order to apply the input signal to the second input. The lower comparator can be designed to receive the input signal and the lower comparison value via inputs of the lower comparator to compare with the lower comparator the input signal with the lower comparison value. A first input of the lower comparator can be connected to the upper capacitor in order to apply the upper comparison value to the first input. A second input of the lower comparator may be connected to the input line of the analog-to-digital converter to apply the input signal to the second input. The upper comparator can be designed to output the upper indication signal if the input signal crosses the upper comparison value. The lower comparator can be designed to output the lower indication signal if the input signal crosses the lower comparison value. The upper comparator and the lower comparator can be connected to the control logic, in particular via separate indication signal lines, to transmit the respective indication signal to the control logic. The upper comparator is usually connected to the control logic via an upper indication signal line to transmit the upper indication signal. The lower comparator is usually connected to the control logic via a lower indication signal line to transmit the lower indication signal. The upper indication signal line and the lower indication signal line can be connected to the same or different inputs of the control logic in order to transmit the indication signals to the control logic. One of the first input and second input of the respective comparator may be an inverting input of the comparator and the other of the first input and second input may be a non-inverting input of the comparator. For example, the first input of the respective comparator may be an inverting input of the respective comparator and the second input of the respective comparator may be a non-inverting input of the respective comparator.

The control logic may comprise a time measurement unit to determine an elapsed time between the crossing of one of the comparison values by the input signal and a subsequent crossing. The subsequent crossing can be a subsequent crossing of the input signal with an upper comparison value, which may be readjusted, or a lower comparison value, which may readjusted. The indication signals and the elapsed times can be used to generate a digital representation of the analog input signal. This can be carried out with the analog-to-digital converter, in particular the control logic. The analog-to-digital converter, in particular the control logic, can be designed to output the digital representation of the analog input signal, usually via an output line of the analog-to-digital converter, based on the indication signals and the elapsed times between the indication signals.

The comparison value generating means can comprise an upper control switch and a lower control switch in order to selectively connect with the upper control switch the upper capacitor to a high charging potential terminal for connecting a high charging potential or a low charging potential terminal for connecting a low charging potential, or usually an off position of the upper control switch, by switching the upper control switch, and in order to selectively connect with the lower control switch the lower capacitor to a high charging potential terminal for connecting a high charging potential or a low charging potential terminal for connecting a low charging potential, or usually an off position of the lower control switch, by switching the lower control switch. Thus, high energy efficiency can be achieved. A high charging potential can be connected to the respective high charging potential terminal and a low charging potential can be connected to the respective low charging potential terminal. The high charging potential is usually higher than the low charging potential. The charging potentials are usually electrical potentials. The off position of the respective control switch can correspond to a switching state of the control switch in which no charging potential is applied to the respective capacitor via the control switch, in particular in which the capacitor is connected via the control switch to a null-connection terminal without charging potential connection. The respective control switch can be controlled, in particular time-dependent, in order to change the charging state of the respective capacitor, in particular to set it, with a controlled connection of the respective capacitor to the charging potentials. In particular, the charging state of the capacitor can be increased by connecting the respective capacitor to the upper charging potential and the charging state of the capacitor can be reduced by connecting the respective capacitor to the lower charging potential. The charging state of the respective capacitor can be represented by a capacitor voltage of the respective capacitor. The high charging potential, with which the upper capacitor can be connected with the upper control switch, and the high charging potential, with which the lower capacitor can be connected with the lower control switch, can be of different sizes or the same size. The low charging potential, with which the upper capacitor can be connected with the upper control switch, and the low charging potential, with which the lower capacitor can be connected with the lower control switch, can be of different sizes or the same size. The respective high charging potential terminal and the respective low charging potential terminal, and especially the null-connection terminal, are usually part of the analog-to-digital converter, in particular of the comparison value generating means, especially of the respective comparison value generation branch. The respective high charging potential and respective low charging potential can be part of the analog-to-digital converter, in particular the comparison value generating means. The charging potential terminals can be inputs of the analog-to-digital converter for connecting electrical charging potentials. In the respective comparison value generation branch, the respective control switch is usually designed to switch selectively between the high charge potential connection and the low charge potential connection and, in particular, the off position of the control switch. The respective control switch is usually connected to the control logic in order to control the switching of the control switch with the control logic, in particular with adjustment signals of the control logic.

The upper capacitor can be connected to the upper control switch via an upper resistor. The lower capacitor can be connected to the lower control switch via a lower resistor. Typically, setting the respective charging state, in particular charging and/or discharging, of the respective capacitor is dependent on a time constant of a charging process of the respective capacitor. The time constant of the charging process of the upper capacitor can be defined with the capacitance of the upper capacitor and the electrical resistance of the upper resistor. The time constant of the charging process of the lower capacitor can be defined with the capacitance of the lower capacitor and the electrical resistance of the lower resistor. The upper capacitor and the upper resistor can form an upper RC circuit. The time constant of the charging process of the upper capacitor can be referred to as the time constant of the upper RC circuit. The upper comparator, in particular its first input, is usually electrically connected to an upper node located between the upper capacitor and the upper resistor. The upper node is usually part of an electrical connection between the upper capacitor and the upper resistor. The upper comparator and/or the upper node can be connected to a first input of the upper capacitor. The second input of the upper capacitor can be connected to a ground potential terminal of the analog-to-digital converter. The lower capacitor and the lower resistor can form a lower RC circuit. The time constant of the charging process of the lower capacitor can be referred to as the time constant of the lower RC circuit. The lower comparator, in particular its first input, is usually electrically connected to a lower node located between the lower capacitor and the lower resistor. The lower node is usually part of an electrical connection between the lower capacitor and the lower resistor. The lower comparator and/or the lower node can be connected to a first input of the lower capacitor. The second input of the lower capacitor may be connected to a ground potential terminal of the analog-to-digital converter. The capacitor voltage of the respective capacitor which represents the charging state of the respective capacitor can be formed between the first input and the second input of the respective capacitor. The time constant of the charging process of the upper capacitor can be formed with, in particular by, a product of an electrical resistance of the upper resistor and a capacitance of the upper capacitor. The time constant of the charging process of the lower capacitor can be formed by a product, in particular by a product, of an electrical resistance of the lower resistor and a capacitance of the lower capacitor.

The upper capacitor and the upper control switch, and in particular the upper resistor, can be part of an upper comparison value generation branch, in particular form this branch. The lower capacitor and the lower control switch, and in particular the lower resistor, can be part of a lower comparison value generation branch, in particular form this branch. The upper comparison value generation branch can be connected between the upper comparator and the control logic. The lower comparison value generation branch can be connected between the lower comparator and the control logic. The upper comparison value generation branch and the upper comparator can be part of an upper sampling branch, in particular form this branch. The lower comparison value generation branch and the lower comparator can be part of a lower sampling branch, in particular form this branch. The respective comparison value generation branch is usually part of the analog-to-digital converter, in particular the comparison value generation means. The respective sampling branch is usually part of the analog-to-digital converter. The analog-to-digital converter can comprise several upper comparison value generation branches and/or several lower comparison value generation branches. The analog-to-digital converter can comprise several upper sampling branches and/or several lower sampling branches. These are preferably connected in parallel to each other. In a comparison of the upper comparison value generation branches with one another, the upper capacitors can have different capacitances and/or the upper resistors can have different electrical resistances. In a comparison of the lower comparison value generation branches with one another, the lower capacitors can have different capacitances and/or the lower resistors can have different electrical resistances. With the respective upper comparison value generation branch, an upper comparison value can be generated for a comparison with the input signal. With the respective lower comparison value generation branch, a lower comparison value can be generated for comparison with the input signal. The upper comparison values can be different from each other. The lower comparison values can be different from each other.

The upper comparison value generation branches can be connected to the upper comparator, in particular via a common input of the lower comparator. The lower comparison value generation branches can be connected to the lower comparator, in particular via a common input of the lower comparator. Preferably, the analog-to-digital converter comprises a plurality of upper comparators, wherein the upper comparison value generation branches are respectively connected to a different one of the upper comparators, in particular its respective first input, in order to generate a respective upper comparison value at the respective comparator with the respective comparison value generation branch. The analog-to-digital converter may comprise a plurality of upper sampling branches, wherein the respective upper comparison value generation branch and respective upper comparator, which are connected to each other for transmitting the respective upper comparison value, are part of, in particular form, one of the upper sampling branches. Different ones of the upper comparison value generation branches are usually part of different ones of the upper sampling branches, in particular form different ones of the upper sampling branches. Preferably, the analog-to-digital converter comprises a plurality of lower comparators, wherein the lower comparison value generation branches are respectively connected to a different one of the lower comparators, in particular its respective first input, to generate a respective lower comparison value at the respective comparator with the respective comparison value generation branch. The analog-to-digital converter may comprise a plurality of lower sampling branches, wherein the respective lower comparison value generation branch and respective lower comparator, which are connected to each other for transmitting the respective lower comparison value, are part of, in particular form, one of the lower sampling branches. Different ones of the lower comparison value generation branches are usually part of different ones of the lower sampling branches, in particular form different ones of the lower sampling branches. Different of the upper comparison value generation branches among each other and/or different of the lower comparison value generation branches among each other can have different time constants of a charging process of their respective capacitors. In this way, different comparison value generation branches can have different charging times of the respective capacitors with different accuracies and/or with different precision. Usually, a faster charging time corresponds to a lower accuracy and/or precision and a slower charging time corresponds to a higher accuracy and/or precision. This enables the analog-to-digital converter to be used efficiently depending on the application.

The respective comparison value generation branch and/or respective sampling branch, in particular the respective components thereof, may be implemented and integrated into the analog-to-digital converter as part of the analog-to-digital converter as described in this document. In particular, the control switch of the respective comparison value generation branch may be connected to the control logic as described in this document to control the control switch with respective adjustment signals of the control logic. In particular, the respective comparator may be connected to the control logic as described in this document to transmit the respective indication signals to the control logic. The control logic may be configured to output respective adjustment signals for controlling the control switch of the respective comparison value generation branch and/or respective sampling branch as described in this document. In particular, the calibration described in this document can be carried out for the respective comparison value generation branch and/or respective sampling branch, in particular separately.

The upper control switch and/or the lower control switch can respectively be connected to the control logic in order to control the switching of the respective control switch with the control logic, in particular with the adjustment signals. The control logic can be designed to output upper adjustment signals to control the switching of the upper control switch and to output lower adjustment signals to control the switching of the lower control switch. The control logic can be connected to the control switches via control lines, in particular to the upper control switch via an upper control line and to the lower control switch via a lower control line, in order to transmit the upper adjustment signals to the upper control switch and the lower adjustment signals to the lower control switch via the control lines to control the switching of the respective control switch. The adjustment signals can be implemented with the upper adjustment signals and the lower adjustment signals. The upper control switch can be controlled, in particular switched, with the control logic, in particular time-dependent, such that a charging state of the upper capacitor corresponding to an upper comparison value to be set, in particular with the comparison value generating means, is set on the upper capacitor, especially the upper capacitor is charged or discharged accordingly. The control logic can be designed and in particular connected to the upper control switch for a corresponding control of the upper control switch. The lower control switch can be controlled, in particular switched, with the control logic, in particular time-dependent, such that a charging state of the lower capacitor corresponding to a lower comparison value to be set, in particular with the comparison value generating means, is set at the lower capacitor, especially the lower capacitor is charged or discharged accordingly. The control logic can be designed and in particular connected to the lower control switch for a corresponding control of the lower control switch.

The control logic can be configured to calculate switching times of the upper control switch and switching times of the lower control switch in order to set a charging state of the respective capacitor corresponding to the respective comparison value to be set with switching the respective control switch based on the respective calculated switching times. Usually, the respective switching times of the upper control switch correspond to the respective upper comparison value to be set and the respective charging state of the upper capacitor. Usually, the switching times of the lower control switch correspond to the respective lower comparison value to be set and/or the respective charging state of the lower capacitor. Usually, with the control logic, the respective adjustment signals are output based on the calculated respective switching times in order to control the switching of the respective control switch with the respective adjustment signals.

The control logic can be configured to calculate the switching times of the respective control switch depending on the current charging state of the respective capacitor and the respective comparison value to be set and, in particular, depending on a time constant corresponding to a charging process, in particular a charging time, of the respective capacitor. The respective time constant can be the time constant described above. The control logic can comprise a calculation unit to calculate the switching times. The control logic can be referred to as control unit, in particular a digital control unit. The control logic can be a logic circuit and/or can be designed as part of a microprocessor or as a microprocessor. The control logic can comprise a memory unit. In the memory unit the respective time constant and/or the respective comparison value to be set and/or, in particular, a digital representation of the respective current charging state of the respective capacitor can be stored, wherein preferably all of the aforementioned are stored in the memory unit. Usually, the digital representation of the current charging state of the respective capacitor is stored in the memory unit. In addition, the respective comparison value to be set or the respective time constant can be stored in the memory unit. Usually, for the respective comparison value generation branch, the calculated switching times of the control switch indicate the times in which the control switch is to be connected to the high charging potential terminal and to the low charging potential terminal in order to change the charging state of the capacitor such that the respective comparison value to be set is set.

The calculation of the switching times of the respective control switch with the control logic can be implemented by evaluating a non-linear function. The non-linear function can be dependent on the current charging state of the respective capacitor and the respective comparison value to be set and, in particular, on the time constant corresponding to a charging process, in particular a charging time, of the respective capacitor. The non-linear function can be implemented in the form of a polynomial. The calculation of the switching times can be computer-implemented, in particular as part of a computer-implemented method. The calculation of the switching times is usually performed during operation of the analog-to-digital converter for converting an input signal into a digital representation, in particular as an operando calculation. In this way, an uncertainty of the switching times can be dependent on a calculation bit length of the calculation with control logic, a clock frequency of the time measurement unit of the control logic and, in particular, a complexity of the non-linear function, especially a degree of the polynomial. This makes it possible to keep the uncertainty of the switching times small in a simple manner. As a result, a high accuracy and/or high precision of the converting of the analog input signal into the digital representation can be achieved.

In particular, it is advantageous if the control logic for the respective comparison value generation branch calculates the switching times of the respective control switch in order to selectively connect with the control switch in the comparison value generation branch the capacitor with the high charging potential terminal and low charging potential terminal, so that the charging state of the capacitor is changed for setting the respective comparison value to be set. The calculation of the switching times with the control logic can be carried out by evaluating the non-linear function depending on the current charging state of the capacitor, the comparison value to be set and the time constant assigned to the capacitor. The control switch of the respective comparison value generation branch can be controlled with the control logic according to the calculated switching times, usually by outputting adjustment signals from the control logic to the control switch. In this way, a small energy footprint combined with high accuracy can be achieved in a particularly practical way.

Usually, the capacitance of the respective capacitor and/or the electrical resistance of the respective resistor exhibit an uncertainty due to production tolerances in their manufacture, so that a respective time constant calculated based on the respective capacitance and the respective electrical resistance exhibits an, often high, uncertainty. This problem can be solved with the calibration described in this document.

A particularly high accuracy and/or particularly high precision of the converting of the analog input signal into the digital representation can be achieved if a calibration of the analog-to-digital converter is carried out to determine the time constant of the charging process of the respective capacitor. For this purpose, the analog-to-digital converter can comprise a calibration function, in particular integrated into the analog-to-digital converter, with which the calibration can be implemented. The analog-to-digital converter can be designed to perform the calibration in an operational state of the analog-to-digital converter for converting an input signal into a digital representation. The calibration can be performed at the beginning of a method of operating the analog-to-digital converter, in particular before converting the input signal into the digital representation. The calibration can be performed simultaneously or at different times, in particular one after the other, for the upper sampling branch to determine the time constant of the charging process of the upper capacitor and for the lower sampling branch to determine the time constant of the charging process of the lower capacitor.

The analog-to-digital converter can be designed and in particular controlled by the control logic for calibrating the analog-to-digital converter so that the respective capacitor with switching of the respective control switch can be connected to a reference potential terminal of the analog-to-digital converter for a predetermined first time, in order to connect the capacitor via the reference potential terminal to a reference potential located between the low charging potential and the high charging potential, after which with switching of the control switch the capacitor can be connected to the respective low charging potential terminal for connecting the respective capacitor to the low charging potential for a predetermined second time, after which with switching of the control switch the capacitor can be connected to the respective high charging potential terminal for connecting the capacitor to the high charging potential and the respective comparator, in particular its second input, can be connected to the reference potential, wherein a third time until a capacitor voltage corresponding to the reference potential is reached at the capacitor can be detected with the control logic, wherein a time constant corresponding to a charging time of the capacitor can be calculated with the control logic. At the end of the second time, the capacitor voltage of the capacitor usually has a discharge value. The discharge value can be calculated with the control logic and is usually undefined before the calculation of the time constant. The discharge value is usually an unknown variable for calculating the time constant, wherein the discharge value may be calculated as part of the calculation of the time constant. The discharge value is usually dependent on the time constant. The first time is usually selected such that a capacitor voltage corresponding to the reference potential is set at the capacitor. For example, the first time can be selected as a multiple of an expected time constant corresponding to the charging process of the capacitor, for example 10 times the expected time constant. The above refers in particular to the respective sampling branch and its components. The third time is usually detected, in particular measured, by the control logic.

The calculation of the respective time constant usually requires solving a non-linear equation system with the for the calculation known, in particular measured, input variables of the second time, the third time and the reference potential and the for the calculation unknown variables of the discharge value and the time constant. This can be solved iteratively, for example. The calculation and/or solving can be carried out with the control logic, in particular its calculation unit. With the calculation, the time constant, and usually the discharge value, can be calculated. The time constant and usually also the discharge value can respectively represent a calculated output variable of the calculation. The calculation of the switching times can be computer-implemented, in particular as part of a computer-implemented method.

The respective reference potential can be part of the analog-to-digital converter. The calibration can be controlled with the control logic. The connecting of the respective comparator, in particular its second input, to the respective reference potential can be implemented with a reference potential switch, wherein the comparator, in particular its second input, can be connected to a reference potential connection of the analog-to-digital converter by switching the reference potential switch. This reference potential connection can be the aforementioned reference potential connection or a further reference potential connection to which the reference potential can be applied. The reference potential switch is usually connected to the control logic in order to control the reference potential switch with the control logic. To detect the third time until a voltage corresponding to the reference potential is set at the capacitor, a comparison value corresponding to the charging state of the capacitor at the comparator, in particular its first input, can be compared with a reference value corresponding to the reference potential at the comparator, in particular its second input, wherein if the comparison value crosses the reference value, a corresponding indication signal, also referred to as reference indication signal, is output by the comparator and, in particular, transmitted to the control logic. The third time can be detected with the control logic based on this indication signal. The above calibration applies in particular to the respective sampling branch, especially the upper sampling branch and the lower sampling branch, separately from each other. The upper sampling branch can comprise the upper capacitor, the upper resistor, the upper control switch and the upper comparator. The lower sampling branch can comprise the lower capacitor, the lower resistor, the lower control switch and the lower comparator.

The input signal is usually an electrical voltage signal. Usually, the respective comparison value is applied to the respective comparator, in particular its first input, in the form of an electrical voltage. A connecting of and/or between electrical components of the analog-to-digital converter described in this document usually refers to an electrical connecting of the components, in particular for transmitting an electrical signal between the components.

A sensor may be provided, wherein the sensor comprises an analog-to-digital converter for converting an analog input signal, in particular an analog measurement signal of the sensor, into a digital representation. The analog-to-digital converter can be implemented and/or operated as described in this document. In this way, the sensor can be operated with high energy efficiency. The sensor can be designed to generate analog measurement data corresponding to a physical and/or chemical variable measured by the sensor, wherein the measurement data forms the analog input signal of the analog-to-digital converter. For example, the sensor can be a temperature sensor or a glass breakage sensor for detecting glass breakage. Preferably, the sensor is designed to detect measurement data, in particular vital parameters, of a body of a living being, in particular a human being. For example, the sensor can be designed to detect heart muscle activity, in particular as part of an electrocardiograph.

To achieve the foregoing further object, the invention provides a method of operating an analog-to-digital converter for converting an analog input signal into a digital representation, wherein with comparison means an upper comparison value and a lower comparison value are compared with the input signal and if the input signal crosses one of the comparison values, a, usually digital, indication signal is output to indicate the crossing of the input signal with the one of the comparison values, wherein with comparison value generating means the upper comparison value and the lower comparison value are generated depending on adjustment signals of a control logic, wherein the comparison value generating means comprise an upper capacitor and a lower capacitor, wherein the upper comparison value depends on a charging state of the upper capacitor and the lower comparison value depends on a charging state of the lower capacitor, wherein in response to the crossing of one of the comparison values by the input signal, the charging states of the capacitors are changed depending on the adjustment signals of the control logic to adjust the comparison values. The method can be carried out with the analog-to-digital converter described in this document. The method of operating an analog-to-digital converter can be designed in accordance with the features and effects described in the context of an analog-to-digital converter, in particular above, in this document. The same applies to the analog-to-digital converter with regard to the method of operating an analog-to-digital converter.

The comparison value generating means comprise an upper control switch and a lower control switch in order to selectively connect with the upper control switch the upper capacitor to a high charging potential terminal or a low charging potential terminal by switching the upper control switch, and in order to selectively connect with the lower control switch the lower capacitor to a high charging potential terminal or a low charging potential terminal by switching the lower control switch. In particular, with the control logic switching times of the upper control switch and switching times of the lower control switch are calculated in order to set a charging state of the respective capacitor corresponding to the respective comparison value to be set with switching the respective control switch based on the respective calculated switching times. Preferably, the switching times of the respective control switch are calculated with the control logic by evaluating a non-linear function depending on a time constant corresponding to a charging time of the respective capacitor, a current charging state of the respective capacitor and a respective comparison value to be set. The respective control switch can be controlled with the control logic according to the respective calculated switching times, usually by outputting adaptation signals from the control logic to the control switch. In this way, a small energy footprint while maintaining high accuracy can be achieved in a particularly practical way.

To achieve the foregoing furthermore object, the invention provides a method of calibrating an analog-to-digital converter as described in this document, wherein with switching of the respective control switch the respective capacitor is connected for a predetermined first time to a reference potential lying between the low charging potential and the high charging potential, whereafter the capacitor is connected with switching of the control switch to the low charging potential for a predetermined second time, whereafter the capacitor is connected to the high charging potential with switching of the respective control switch and the respective comparator is connected to the reference potential, wherein a third time until a voltage corresponding to the reference potential is set at the capacitor is detected with the control logic, whereafter a time constant corresponding to a charging time of the respective capacitor is calculated with the control logic. In this way, the time constant of the charging process of the respective capacitor can be determined, whereby a high accuracy and/or high precision of the converting of the analog input signal into the digital representation can be achieved. The determined time constant can be stored with the control logic, in particular a memory unit of the control logic. The calibration can be carried out at the beginning of the method for operating the analog-to-digital converter, in particular before converting the input signal into the digital representation. The calibration can be carried out for the upper sampling branch to determine the time constant of the charging process of the upper capacitor and for the lower sampling branch to determine the time constant of the charging process of the lower capacitor at the same time or at different times, in particular one after the other. With the calibration, conversion parameters, in particular the time constants, of the analog-to-digital converter can be determined for performing a conversion of an analog input signal into a digital representation.

The calibration can be controlled by the control logic. The connecting of the respective comparator, in particular its second input, to the respective reference potential can be implemented with a reference potential switch of the analog-to-digital converter, whereby switching of the reference potential switch is usually controlled with the control logic. The reference potential switch can be connected between the reference potential terminal and the respective comparator, in particular its second input. To determine the third time until a voltage corresponding to the reference potential is reached at the capacitor, with the comparator a comparison value corresponding to the charging state of the capacitor at the comparator, in particular its first input, can be compared with a reference value corresponding to the reference potential at the comparator, in particular its second input, and, if the comparison value crosses the reference value, a corresponding indication signal can be output by the comparator and, in particular, transmitted to the control logic. The above calibration applies in particular to the respective sampling branch, especially the upper sampling branch and the lower sampling branch, each separately from the other. The upper sampling branch can be formed with the upper capacitor, the upper resistor, the upper control switch and the upper comparator. The lower sampling branch can be formed with the lower capacitor, the lower resistor, the lower control switch and the lower comparator.

The method of calibrating can be performed with the analog-to-digital converter described in this document. The method of calibrating may be implemented as part of the method of operating an analog-to-digital converter, in particular at the beginning of the method of operating an analog-to-digital converter. The method of calibrating can be implemented in accordance with the features and effects described in the context of an analog-to-digital converter and/or in the context of a method of operating an analog-to-digital converter, in particular as described above in this document. The same applies to the analog-to-digital converter and/or the method of operating an analog-to-digital converter with respect to the method of calibrating an analog-to-digital converter.

The invention will now be described by way of example with reference to the accompanying drawings, in which:
Fig. 1 shows a schematic illustration of an analog input signal and a conversion carried out with an analog-to-digital converter by means of level crossing into a digital representation, as is known from the prior art;
Fig. 2 shows a schematic illustration of a circuit diagram of an analog-to-digital converter for performing a conversion by means of level crossing, as is known from the prior art;
Fig. 3 shows a schematic representation of a circuit diagram of an analog-to-digital converter, with reference value generating means comprising an upper capacitor and a lower capacitor;
Fig. 4 shows a schematic representation of a circuit diagram of an analog-to-digital converter with a calibration functionality of the analog-to-digital converter integrated into the analog-to-digital converter;
Fig. 5 shows a schematic illustration of discharging and charging the respective capacitor as part of a calibration with the calibration functionality of the analog-to-digital converter;
Fig. 6 shows a schematic illustration of a circuit diagram of an analog-to-digital converter with several upper sampling branches and several lower sampling branches.

In Fig. 1, a schematic illustration of an analog input signal Vᵢ and a conversion of the input signal Vᵢ carried out with an analog-to-digital converter 1 by means of level crossing into a digital representation of the input signal Vᵢ, as is known from the prior art, is shown. In Fig. 1, the analog input signal is shown in the upper graph in the form of a signal voltage of the input signal over time, also referred to as a representation of the input signal in a signal space. In level crossing sampling, data is acquired when the input signal Vᵢ crosses predefined comparison values, indicated as dashed lines in the upper graph. For example, comparison values spaced at equal intervals can be provided for this purpose, whereby a +1 spike is generated when the input signal Vᵢ crosses one of the comparison values upwards and a -1 spike is generated when the input signal Vᵢ crosses one of the comparison values downwards. In Fig. 1, the lower graph shows the digital representation in the form of digital signals, formed with the +1 spikes and -1 spikes, over time, also referred to as the representation of the input signal Vᵢ in an event space. The digital representation, in particular the time-dependent depiction of the spikes, enables reconstruction of the analog input signal. A practicable control can be achieved if, in relation to an actual value of the input signal Vᵢ, a next higher comparison value and a next lower comparison value of the comparison values are generated and a crossing of the input signal Vᵢ with the upper comparison value or the lower comparison value is detected, wherein in the event of a crossing the upper comparison value and lower comparison value are readjusted.

Fig. 2 shows a schematic illustration of a circuit diagram of an analog-to-digital converter 1 known from the prior art. The analog-to-digital converter 1 has a control logic 2, an upper comparator Kᵤ, a lower comparator Kₗ, an upper digital-to-analog unit 3 and a lower digital-to-analog unit 4. With the control logic 2 a respective upper comparison value X, and a respective lower comparison value Xₗ is output in digital form. The digital upper comparison value is converted by the upper digital-to-analog unit 3 into an analog upper comparison value, the digital lower comparison value is converted into an analog lower comparison value. The input signal Vᵢ and the analog upper comparison value are fed to the upper comparator K, to compare with the upper comparator K, the input signal Vᵢ with the upper analog comparison value and, if the input signal Vᵢ crosses the upper comparison value, to output an upper indication signal Iᵤ to the control logic 2. The input signal Vᵢ and the lower analog comparison value are fed to the lower comparator Kₗ in order to compare with the lower comparator Kₗ the input signal Vᵢ with the lower analog comparison value and, if the input signal Vᵢ crosses the lower comparison value, to output a lower indication signal Iₗ to the control logic 2. Typically, such an implementation with digital-to-analog units requires a high operating power and is not suitable for energy-efficient applications.

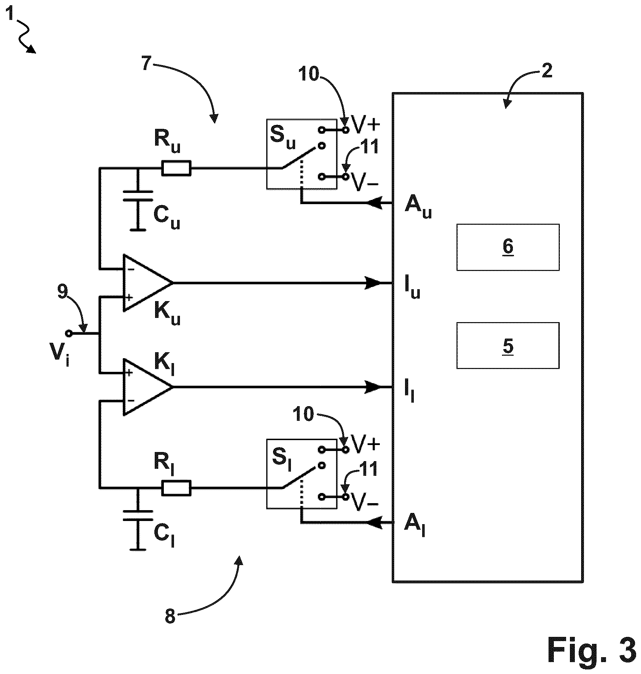

Fig. 3 shows a schematic illustration of a circuit diagram of an analog-to-digital converter 1 for converting an analog input signal Vᵢ into a digital representation, wherein the analog-to-digital converter 1 comprises comparison means for comparing an upper comparison value and a lower comparison value with the input signal Vᵢ, wherein the comparison means comprise an upper comparator Kᵤ and a lower comparator Kₗ, to compare with the upper comparator K, the input signal Vᵢ with the upper comparison value and to compare with the lower comparator Kₗ the input signal Vᵢ with the lower comparison value, wherein if the input signal Vᵢ crosses the upper comparison value, the upper comparator K, outputs an upper indication signal Iᵤ and if the input signal Vᵢ crosses the lower comparison value, the lower comparator Kₗ outputs a lower indication signal Iₗ to indicate the respective crossing. With the upper indication signal Iᵤ and the lower indication signal Iₗ, an indication signal which is output with the comparison means and which indicates a crossing of the input signal Vᵢ with one of the comparison values is practicably implemented. The upper comparator Kᵤ can be connected via an upper indication signal line and the lower comparator Kₗ can be connected via a lower indication signal line to a digital control logic 2 of the analog-to-digital converter 1 in order to transmit the upper indication signal Iᵤ and lower indication signal Iₗ to the control logic 2. The control logic 2 comprises a time measurement unit 5 to determine an elapsed time between the crossing of the input signal Vᵢ with one of the comparison values and a subsequent crossing.

The analog-to-digital converter 1 comprises comparison value generating means for generating the upper comparison value and the lower comparison value depending on adjustment signals Aᵤ, Aₗ of the control logic 2. The comparison value generating means comprise an upper comparison value generation branch 7, which connects between a first input of the upper comparator K, and the control logic 2, and a lower comparison value generation branch 8, which connects between a first input of the lower comparator Kₗ and the control logic 2. The upper comparison value generation branch 7 and the upper comparator K, may be referred to as the upper sampling branch. The lower comparison value generation branch 8 and the lower comparator Kₗ may be referred to as the lower sampling branch. With the upper comparison value generation branch 7, the upper comparison value can be generated and applied to the first input of the upper comparator Kᵤ. With the lower comparison value generation branch 8, the lower comparison value can be generated and applied to the first input of the lower comparator Kₗ. The analog-to-digital converter 1 comprises an input line 9 which is connected to a second input of the upper comparator K, and a second input of the lower comparator Kₗ in order to transmit via the input line 9 the input signal Vᵢ to the respective second input. The input signal Vᵢ is usually applied to the input signal line 9 in the form of an input signal voltage of the input signal Vᵢ. The first input of the respective comparator can be an inverting input of the respective comparator and the second input of the respective comparator can be a non-inverting input of the respective comparator. The upper components and/or the components of the upper sampling branch, in particular of the upper comparison value generation branch, are indicated by the index u. The lower components and/or the components of the lower sampling branch, in particular of the lower comparison value generation branch, are indicated with the index I.

The upper comparison value generation branch 7 comprises an upper capacitor Cᵤ, an upper resistor Rᵤ and an upper control switch Sᵤ connected together. The first input of the upper comparator Kᵤ is connected to an upper node of the upper comparison value generation branch 7 located between the upper capacitor C, and the upper resistor Rᵤ. The upper comparison value, which particularly applies to the first input of the upper comparator Kᵤ, depends on the charging state of the upper capacitor Cᵤ. The lower comparison value generation branch 8 comprises a lower capacitor Cₗ, a lower resistor Rₗ and a lower control switch Sₗ connected together. The first input of the lower comparator Kₗ is connected to a lower node of the lower comparison value generation branch 8 located between the lower capacitor Cₗ and the lower resistor Rₗ. The lower comparison value, which particularly applies to the first input of the lower comparator Kₗ, depends on a charging state of the lower capacitor Cₗ.

In the respective comparison value generation branch 7, 8, the capacitor Cᵤ, Cₗ can be selectively connected to a high charging potential terminal 10 for applying a high charging potential V+ or a low charging potential terminal 11 for applying a low charging potential V-, or usually an off position of the respective control switch Sᵤ, Sₗ, by controlling the control switch Sᵤ, Sₗ, in order to change a charging state of the capacitor Cᵤ, Cₗ by controlling the control switch Sᵤ, Sₗ. The high charging potential terminal and the low charging potential terminal are usually part of the respective comparison value generation branch 7, 8. In this way, the charging state of the capacitor Cᵤ, Cₗ and thus the comparison value corresponding to the charging state of the capacitor can be changed, in particular set, by controlling the control switch Sᵤ, Sₗ. The capacitor Cᵤ, Cₗ is connected to the control switch Sᵤ, Sₗ via the resistor Rᵤ, Rₗ. A time constant of a charging process of the capacitor is usually defined by a product of the capacitance of the capacitor and an electrical resistance of the resistor. The control switch Sᵤ, Sₗ is connected to the control logic 2 in order to control the control switch depending on adjustment signals Aᵤ, Aₗ of the control logic 2 in a time-dependent manner with the control logic 2. In particular, the above applies separately to the upper comparison value generation branch 7 and the lower comparison value generation branch 8 and their respective components. In particular, the upper control switch S, and the lower control switch Sₗ can be connected separately from each other to the control logic 2 in order to control the upper control switch S, and the lower control switch Sₗ separately from each other with adjustment signals Aᵤ, Aₗ of the control logic 2. The control logic 2 can comprise a calculation unit 6 which is configured to calculate the switching times of the respective control switch Sᵤ, Sₗ by evaluating a non-linear function depending on a respective actual charging state of the respective capacitor Cᵤ, Cₗ and a respective comparison value to be set as well as the time constant corresponding to a charging process of the respective capacitor Cᵤ, Cₗ. This applies in particular with regard to the respective comparison value generation branch 7, 8. In response to a crossing of the input signal Vᵢ with one of the comparison values, the control logic 2 is usually designed to control the upper control switch Sᵤ with output of upper adjustment signals A, to change the upper comparison value and to control the lower control switch Sₗ with output of lower adjustment signals Aₗ to change the lower comparison value.

Typically, with the calculation unit for the respective comparison value generation branch, the switching times of the control switch to selectively connect with the control switch the capacitor with the high charging potential terminal and the low charging potential terminal are calculated, so that the charging state of the capacitor is changed for setting the respective comparison value to be set, wherein the switching times are calculated with the control logic by evaluating the non-linear function depending on the respective current charging state of the capacitor, the comparison value to be set and the time constant assigned to the capacitor. The respective control switch can be controlled with the control logic, usually by adjustment signals from the control logic to the control switch, according to the calculated switching times. The control logic can comprise a memory unit in which for the respective comparison value generation branch the time constant assigned to the capacitor and a digital representation of the respective current state of charge of the capacitor and, usually, the respective comparison value to be set are stored in order to calculate the switching times based on these with the calculation unit.

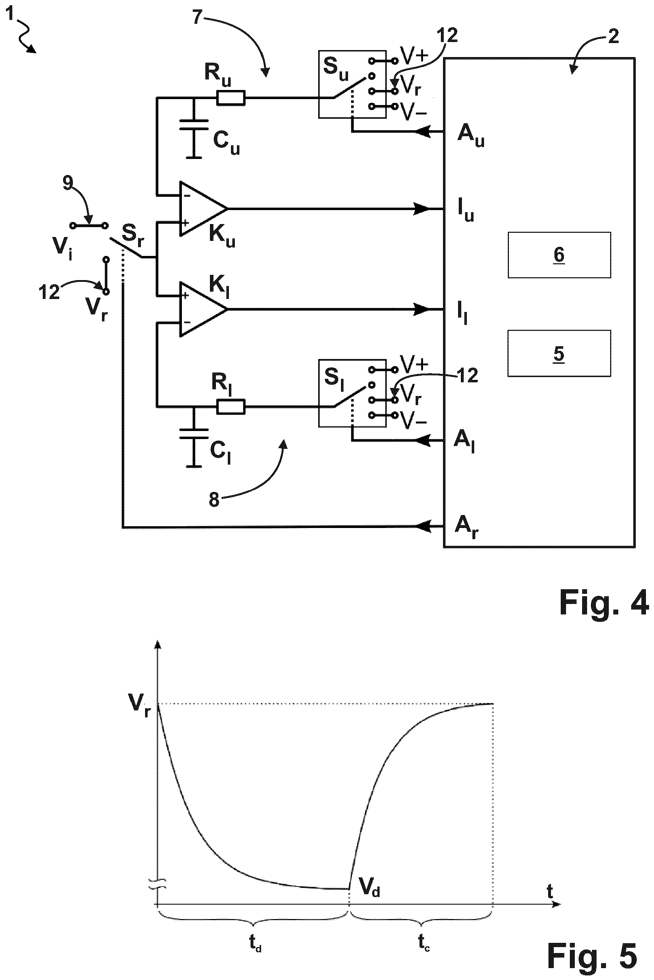

Fig. 4 shows a schematic illustration of a circuit diagram of an analog-to-digital converter 1 with a calibration functionality of the analog-to-digital converter 1 integrated into the analog-to-digital converter 1. With the calibration, a respective time constant, which corresponds to a charging process of the respective capacitor Cᵤ, Cₗ, can be determined. The analog-to-digital converter 1 is designed accordingly to the analog-to-digital converter 1 described in Fig. 3. In addition, in the respective comparison value generation branch 7, 8, the control switch Sᵤ, Sₗ, besides the high charging potential terminal 10, the low charging potential terminal 11 and the off position, can also be selectively connected to a reference potential terminal 12 of the respective comparison value generation branch 7, 8 in order to connect the capacitor Cᵤ, Cₗ to a reference potential V, applied to the reference potential terminal 12 by switching the control switch. The reference potential is usually between the high charging potential V+ applied to the high charging potential terminal 10 and the low charging potential V- applied to the low charging potential terminal 11. The analog-to-digital converter 1 comprises a reference potential switch S, in order to connect the second inputs of the comparators to a reference potential terminal 12, in particular the aforementioned or further reference potential terminal 12, which is connected to the reference potential Vᵣ, by switching the reference potential switch Sᵣ. The reference potential switch S, is connected to the control logic 2 in order to control the reference potential switch Sᵣ with the control logic 2. The calibration relates in particular to the respective comparison value generation branch 7, 8 and the respective comparator Kᵤ, Kₗ connected to it, in particular to the respective sampling branch.

To calibrate the analog-to-digital converter 1, in the respective sampling branch, in particular in the respective comparison value generation branch 7, 8, the capacitor Cᵤ, Cₗ is connected to the reference potential terminal 12 for a predetermined first time by switching the control switch Sᵤ, Sₗ, in order to connect the capacitor Cᵤ, Cₗ via the reference potential terminal 12 to the reference potential Vᵣ which is between the low charging potential 11 and the high charging potential 12, whereafter the capacitor Cᵤ, Cₗ is connected to the low charging potential terminal 11 for a predetermined second time t_{d} by switching the control switch Sᵤ, Sₗ, wherein at the end of the second time t_{d} the capacitor voltage of the capacitor Cᵤ, Cₗ has a discharge value V_{d}, whereafter the capacitor Cᵤ, Cₗ is connected to the high charging potential terminal 10 by switching the control switch Sᵤ, Sₗ, and the corresponding comparator Kᵤ, Kₗ, in particular its second input, is connected to the reference potential terminal 12 by switching the reference potential switch Sᵣ, whereafter a third time t_{c} until a capacitor voltage corresponding to the reference potential Vᵣ is reached at the capacitor Cᵤ, Cₗ is detected by the control logic 2, whereafter a time constant corresponding to a charging time of the respective capacitor is calculated by the control logic 2, in particular by its calculation unit 6. In Fig. 5, a graph shows exemplary a capacitor voltage of the capacitor Cᵤ, Cₗ during the second time t_{d} and during the third time t_{c}, wherein at the end of the second time t_{d} the capacitor is discharged to the discharge value V_{d} of the capacitor voltage and is subsequently charged to a reference voltage of the capacitor voltage corresponding to the reference potential V, at the end of the third time t_{c}. The first time is usually selected such that a capacitor voltage corresponding to the reference potential Vᵣ is set at the capacitor. The calibration can be carried out separately for the upper sampling branch to calculate the time constant assigned to the upper capacitor C, and/or for the lower sampling branch to calculate the time constant assigned to the lower capacitor Cₗ, in particular one after the other or simultaneously.

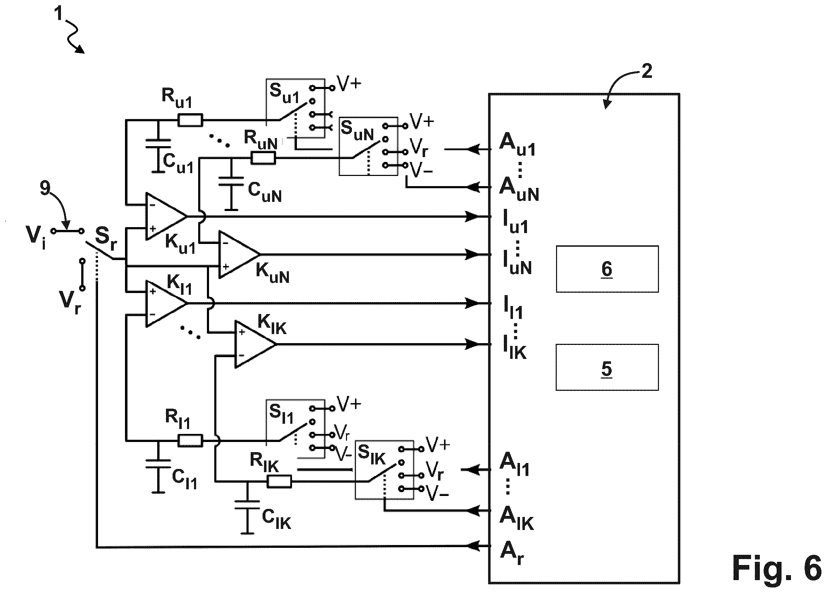

Fig. 6 shows a schematic illustration of a circuit diagram of an analog-to-digital converter 1 with several upper sampling branches and several lower sampling branches. In Fig. 6, the upper sampling branches and their components are designated by the index u1 to uN, where N indicates the number of upper sampling branches, and the lower sampling branches and their components are designated by the index I1 to IK, where K indicates the number of lower sampling branches. The analog-to-digital converter 1 is designed analogously to the analog-to-digital converter 1 of Fig. 3, wherein the respective upper sampling branch is designed analogously to the upper sampling branch of Fig. 3 and the respective lower sampling branch is designed analogously to the lower sampling branch of Fig. 3. The sampling branches, in particular the respective sampling branch, can be controlled with the control logic 2 of the analog-to-digital converter 1 as described for Fig. 3. Different of the upper comparison value generation branches 7 with each other and/or different of the lower comparison value generation branches 8 with each other can have different time constants for a charging process of their respective capacitors. In this way, different of the comparison value generation branches can have different charging times of the respective capacitors with different accuracies and/or different precision. In addition, the analog-to-digital converter 1 can comprise a calibration functionality integrated into the analog-to-digital converter 1. The calibration functionality can be designed analogously to Fig. 4, wherein the respective upper sampling branch is designed analogously to the upper sampling branch of Fig. 4 and the respective lower sampling branch is designed analogously to the lower sampling branch of Fig. 4. The calibration can be implemented for the respective sampling branch as described for Fig. 4.

## Claims

1. Analog-to-digital converter (1) for converting an analog input signal (Vᵢ) into a digital representation, the analog-to-digital converter (1) comprising comparison means for comparing an upper comparison value and a lower comparison value with the input signal (Vᵢ) and for outputting an indication signal indicating a crossing of the input signal (Vᵢ) with one of the comparison values, and comparison value generating means for generating the upper comparison value and the lower comparison value depending on adjustment signals (Aᵤ, Aₗ) of a control logic (2) of the analog-to-digital converter (1), **characterized in that** the comparison value generating means comprise an upper capacitor (Cᵤ) and a lower capacitor (Cₗ), wherein the upper comparison value depends on a charging state of the upper capacitor (Cᵤ) and the lower comparison value depends on a charging state of the lower capacitor (Cₗ), wherein in response to the crossing of the input signal (Vᵢ) with one of the comparison values for adjusting the comparison values, the charging states of the capacitors (Cᵤ, Cₗ) are changeable depending on the adjustment signals (Aᵤ, Aₗ) of the control logic (2).

2. Analog-to-digital converter (1) according to claim 1, wherein the comparison means comprise an upper comparator (Kᵤ) and a lower comparator (Kₗ) to compare with the upper comparator (Kᵤ) the input signal (Vᵢ) with the upper comparison value and to compare with the lower comparator (Kₗ) the input signal (Vᵢ) with the lower comparison value, wherein the respective comparator transmits a corresponding digital indication signal (Iᵤ, Iₗ) to the control logic (2) if the respective comparison value is crossed by the input signal (Vᵢ) to indicate the crossing.

3. Analog-to-digital converter (1) according to claim 1 or 2, wherein the control logic (2) comprises a time measurement unit (5) to determine an elapsed time between the crossing of one of the comparison values by the input signal (Vᵢ) and a subsequent crossing to generate with the digital indication signal (Iᵤ, Iₗ) and the elapsed time a digital representation of the analog input signal (Vᵢ).

4. Analog-to-digital converter (1) according to any one of the claims 1 to 3, wherein the comparison value generating means comprise an upper control switch (Sᵤ) and a lower control switch (Sₗ) in order to selectively connect the upper capacitor (Cᵤ) to a high charging potential terminal (10) or a low charging potential terminal (11), or usually an off position of the upper control switch (Sᵤ), by switching the upper control switch (Sᵤ), and in order to selectively connect the lower capacitor (Cₗ) to a high charging potential terminal (10) or a low charging potential terminal (11), or usually an off position of the lower control switch (Sₗ), by switching the lower control switch (Sₗ).

5. Analog-to-digital converter (1) according to claim 4, wherein the upper capacitor (Cᵤ) is connected to the upper control switch (Sᵤ) via an upper resistor (Rᵤ) and the lower capacitor (Cₗ) is connected to the lower control switch (Sₗ) via a lower resistor (Rₗ).

6. Analog-to-digital converter (1) according to claim 4 or 5, wherein the upper control switch (Sᵤ) and/or the lower control switch (Sₗ) are respectively connected to the control logic (2) in order to control the switching of the respective control switch with the control logic (2), in particular with the adjustment signals.

7. Analog-to-digital converter (1) according to claim 6, wherein the control logic (2) is configured to calculate switching times of the upper control switch (Sᵤ) and switching times of the lower control switch (Sₗ), in particular by evaluating a non-linear function, in order to set a charging state of the respective capacitor (Cᵤ, Cₗ) corresponding to the respective comparison value to be set with switching the respective control switch (Sᵤ, Sₗ) based on the respective calculated switching times.

8. Analog-to-digital converter (1) according to claim 7, wherein the control logic is configured to calculate the switching times of the respective control switch (Sᵤ, Sₗ) by evaluating a non-linear function.

9. Analog-to-digital converter (1) according to claim 7 or 8, wherein the control logic (2) is configured to calculate the switching times of the respective control switch (Sᵤ, Sₗ) depending on a time constant corresponding to a charging time of the respective capacitor (Cᵤ, Cₗ), a current charging state of the respective capacitor (Cᵤ, Cₗ) and a respective comparison value to be set.

10. Analog-to-digital converter (1) according to any one of the claims 4 to 9, wherein, for calibrating the analog-to-digital converter (1), the respective capacitor (Cᵤ, Cₗ) with switching of the respective control switch (Sᵤ, Sₗ) can be connected to a reference potential terminal (12) of the analog-to-digital converter (1) for a predetermined first time, in order to connect the capacitor via the reference potential terminal (12) to a reference potential (V,) located between the low charging potential (V-) and the high charging potential (V+), after which with switching of the control switch the capacitor can be connected to the respective low charging potential terminal (10) for connecting the capacitor to the low charging potential for a predetermined second time (t_{d}), after which with switching of the control switch the capacitor can be connected to the respective high charging potential terminal (10) for connecting the capacitor to the high charging potential, and the respective comparator (Kᵤ, KI), in particular its second input, can be connected to the reference potential (Vᵣ), wherein a third time (t_{c}) until a capacitor voltage corresponding to the reference potential (Vᵣ) is reached at the capacitor can be detected with the control logic (2), wherein a time constant corresponding to a charging time of the capacitor can be calculated with the control logic (2).

11. Sensor, comprising an analog-to-digital converter for converting an analog input signal, in particular an analog measurement signal of the sensor, into a digital representation, **characterized in that** the analog-to-digital converter is designed according to one of the claims 1 to 10.

12. Sensor according to claim 11, wherein the sensor is designed to detect health parameters of a living being, in particular a human being.

13. Method of operating an analog-to-digital converter (1), in particular according to any one of the claims 1 to 10, for converting an analog input signal (Vᵢ) into a digital representation, wherein with comparison means an upper comparison value and a lower comparison value are compared with the input signal (Vᵢ) and if the input signal (Vᵢ) crosses one of the comparison values, a, usually digital, indication signal is output to indicate the crossing of the input signal (Vᵢ) with the one of the comparison values, wherein with comparison value generating means the upper comparison value and the lower comparison value are generated depending on adjustment signals (Aᵤ, Aₗ) of a control logic (2), **characterized in that** the comparison value generating means comprise an upper capacitor (Cᵤ) and a lower capacitor (Cₗ), wherein the upper comparison value depends on a charging state of the upper capacitor (Cᵤ) and the lower comparison value depends on a charging state of the lower capacitor (Cₗ), wherein in response to the crossing of one of the comparison values by the input signal (Vᵢ), the charging states of the capacitors (Cᵤ, Cₗ) are changed depending on the adjustment signals (Aᵤ, Aₗ) of the control logic (2) to adjust the comparison values.

14. Method according to claim 13, wherein the comparison value generating means comprise an upper control switch (Sᵤ) and a lower control switch (Sₗ) in order to selectively connect with the upper control switch (Sᵤ) the upper capacitor (Cᵤ) to a high charging potential terminal (10) or a low charging potential terminal (11) by switching the upper control switch (Sᵤ), and in order to selectively connect with the lower control switch (Sₗ) the lower capacitor (Cₗ) to a high charging potential terminal (10) or a low charging potential terminal (11) by switching the lower control switch (Sₗ), wherein with the control logic (2) switching times of the upper control switch (Sᵤ) and switching times of the lower control switch (Sₗ) are calculated in order to set a charging state of the respective capacitor (Cᵤ, Cₗ) corresponding to the respective comparison value to be set with switching the respective control switch (Sᵤ, Sₗ) based on the respective calculated switching times, wherein the switching times of the respective control switch (Sᵤ, Sₗ) are calculated by evaluating a non-linear function depending on a time constant corresponding to a charging time of the respective capacitor (Cᵤ, Cₗ), a current charging state of the respective capacitor (Cᵤ, Cₗ) and a respective comparison value to be set.

15. Method of calibrating an analog-to-digital converter (1) according to any one of the claims 4 to 10, wherein with switching of the respective control switch (Sᵤ, Sₗ) the respective capacitor (Cᵤ, Cₗ) is connected for a predetermined first time to a reference potential (Vᵣ) lying between the low charging potential (V-) and the high charging potential (V+), whereafter the capacitor (Cᵤ, Cₗ) is connected with switching of the control switch (Sᵤ, Sₗ) to the low charging potential (V-) for a predetermined second time (t_{d}), whereafter the capacitor (Cᵤ, Cₗ) is connected to the high charging potential (V+) with switching of the respective control switch (Sᵤ, Sₗ) and the respective comparator (Kᵤ, KI) is connected to the reference potential (Vᵣ), wherein a third time (t_{c}) until a voltage corresponding to the reference potential (Vᵣ) is set at the capacitor (Cᵤ, Cₗ) is detected with the control logic (2), whereafter a time constant corresponding to a charging time of the respective capacitor (Cᵤ, Cₗ) is calculated with the control logic (2).
